# EUROPEAN PATENT APPLICATION

(11) **EP 3 702 488 A1**
(43) Date of publication of application: **02.09.2020**
(21) Application number: 19382145.1
(22) Date of filing: 27.02.2019
(51) Int. Cl.: C23C 14/02, C23C 14/06, C23C 28/00, C23C 30/00

(54) **EXTERNAL WALL FOR A HOUSING OF A HOME APPLIANCE**

(71) Applicant: BSH Hausgeräte GmbH, 81739 München (DE); BSH Electrodomésticos España, S.A., 50016 Zaragoza (ES)
(72) Inventor: Martinez Solanas, Elena, 50015 Zaragoza (ES); Alaman Aguilar, Jorge, 50012 Zaragoza (ES); Alonso Lozano, Sergio, 50006 Zaragoza (ES); Royo Sanchez, Raquel, 50017 Zaragoza (ES)

(57) **Abstract**

The present invention relates to an external wall (1), particularly for a housing of a home appliance, comprising a substrate (2), a first layer (3) arranged on the substrate (2), and a second layer (4) arranged on the first layer (3). The material of the substrate (3) comprises or is stainless steel. According to the invention, the material of the first layer (2) comprises or is titanium (Ti), and the material of the second layer (4) comprises or is titanium aluminum nitride (AITiN). Alternatively, according to the invention, the material of the first layer (3) comprises or is chrome (Cr) and the material of the second layer (4) comprises or is diamond-like-carbon (DLC).

## Description

The present invention relates to an external wall for a housing of a home appliance. The invention also refers to a housing for a home appliance. The invention further refers to a home appliance comprising such an external wall or housing.

Modern household appliances are typically equipped with external walls made of a metal. The metal surface of these external walls are usually cleaned frequently by the user of the household appliance to remove traces of use such as fingerprints or the like. This proves to be relatively costly with conventional metal surfaces and requires careful cleaning of the surface.

It is therefore an object of the present invention to create an external wall for a household appliance whose surface is particularly easy to clean.

This problem is solved by the subject matter of the independent patent claims. Preferred embodiments are the subject matter of the dependent patent claims.

The basic idea of the invention is therefore to choose the raw material for an external wall of a household appliance - this is referred to as "substrate" in the following - steel or aluminum and to coat it twice. If suitable materials are chosen, surfaces can be created that are particularly resistant to dirt and can be cleaned very easily by the user of the appliance, especially after it has been used. This not only facilitates the handling of the external wall and the use of the household appliance, but also provides a fine attractive appearance of the household appliance, especially if it is not in use.

An external wall according to a first aspect of the invention, particularly for a housing of a home appliance, comprises a substrate, a first layer arranged on the substrate, and a second layer arranged on the first layer. The material of the substrate comprises or is stainless steel. According to the first aspect of the invention, the material of the first layer comprises or is titanium (Ti), and the material of the second layer comprises or is titanium aluminum nitride (AlTiN). Alternatively, the material of the first layer comprises or is chrome (Cr), and the material of the second layer comprises or is diamond-like-carbon (DLC). It has been shown that such a coating with two layers of the above-described materials arranged on top of each other has the desired properties, i.e. is particularly easy to clean, has a long service life due to its high wear resistance and is visually appealing to the observer.

According to a preferred embodiment, the material of the first layer is chrome (Cr) or Cr-CrN-CrCN. Both materials have a particularly high wear resistance and are associated with a long service life of the coating.

An external wall according to a second aspect of the invention, particularly for a housing of a home appliance, comprises a substrate, a first layer arranged on the substrate, and a second layer arranged on the first layer. The material of the substrate comprises or is aluminum. The material of the first layer comprises titanium (Ti), and the material of the second layer comprises titanium nitride (TiN). Alternatively, the material of the first layer comprises chrome (Cr), and the material of the second layer comprises chrome nitride (CrN). It has been shown that such a coating with two layers of the above-mentioned materials arranged on top of each other has the desired properties, i.e. is particularly easy to clean, has a long service life due to its high wear resistance and is visually appealing to the observer.

According to a preferred embodiment of the external wall according to the first or second aspect, a total layer thickness of the first and second layer is between 1 µm and 5 µm. Experimental investigations have shown that a surface coating with such a layer thickness proves to be particularly wear-resistant. This is accompanied by a particularly long service life of.

According to another a preferred embodiment, the external wall forms part of a control panel for controlling at least one component of the home appliance.

According to another preferred embodiment, the external wall forms part a soleplate of an iron.

According to another preferred embodiment, the external wall forms part of a gas burner cap and/or a pan support of a gas hob.

The invention also refers to a housing for a home appliance. The housing comprises at least one external wall according to the invention described above. The advantages of the external wall described above are therefore also transferred to the inventive housing.

The invention also refers to a home appliance comprising a housing according to the invention and/or at least one external wall according to the invention. The advantages of the housing described above are therefore also transferred to the inventive home appliance.

Further important features and advantages of the invention can be gathered from the sub-claims, from the drawings and from the associated figure description using the drawings.

It goes without saying that the features mentioned above and those still to be explained below can be used not only in the respectively specified combination but also in other combinations or on their own without departing from the scope of the present invention.

Preferred examples of the execution of the invention are shown in the drawings and are explained in more detail in the following description.

They are shown schematically,
- Fig. 1:: a schematic view an external wall;
- Fig. 2:: shows a schematic view of a control panel of a home appliance;
- Fig. 3:: shows a schematic view of a soleplate of an iron;
- Fig. 4:: shows a schematic view of a gas burner cap and a pan support of a gas hob.

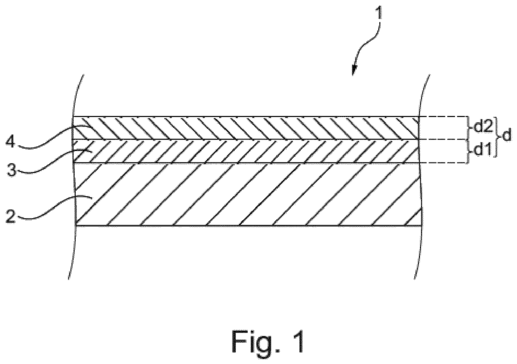

Figure 1 shows in a schematic view a first example of an external wall 1 according to the invention. The external wall 1 can be part of a housing (not shown) of a home appliance (not shown). The external wall 1 comprises a substrate 2, a first layer 3 arranged on the substrate 2, and a second layer 4 arranged on the first layer 3. In the first example, the material of the substrate 4 is stainless steel. The material of the first layer 3 is titanium (Ti). The material of the second layer 4 is titanium aluminum nitride (AlTiN). A first layer thickness d₁ of the first layer 3 is in the range between 100nm and 200nm, preferably around 150nm. A second layer thickness d₂ of the second layer 4 is in the range between 1000nm and 1500nm, preferably around 1250nm.

Alternatively, in the first example, the material of the first layer 3 can be chrome (Cr) or Cr-CrN-CrCN, and the material of the second layer 4 can be diamond-like-carbon (DLC). In this example, the first layer thickness d₁ of the first layer 3 is in the range between 700nm and 1000nm, preferably around 150nm. Moreover, the second layer thickness d₂ of the second layer 4 is in the range between 1000nm and 1500nm, preferably around 1250nm.

According to a second example of the invention, the material of the substrate 2 is aluminum. In the second example, the material of the first layer 3 is chrome (Cr) and the material of the second layer 4 is chrome nitride (CrN). In this example, a total layer thickness d of the first and the second layer 3, 4 is in the range between 4000nm and 4500nm, preferably around 4200nm.

Alternatively, in the second example, the material of the first layer 3 can be titanium (Ti), and the material of the second layer 4 can be diamond-like-carbon (DLC). In this example, a total layer thickness d of the first and the second layer 3, 4 is in the range between 3000nm and 3500nm, preferably around 3150nm.

In all examples described above, the preferred total layer thickness d of the first and second layer 3, 4 is in the range between 1 µm and 5 µm. In all examples described above, the first and the second layer 3, 4 can be deposited on the substrate by means of plasma vapor deposition (PVD).

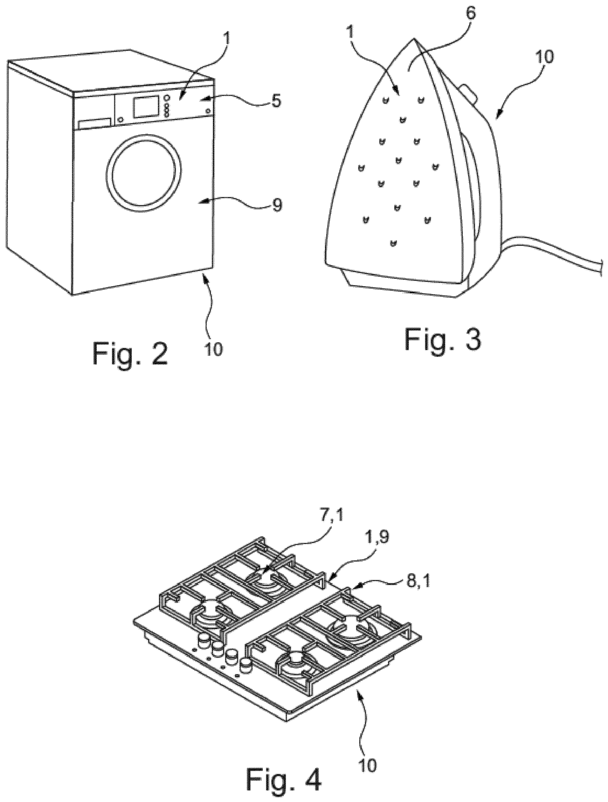

Figure 2 shows a second example of an external wall 1 which forms part of a control panel 5 for controlling at least one component of the home appliance 10. Housing 9 is also shown and the external wall can also form part of the housing 9 of the home appliance 10.

Figure 3 shows a third example of an external wall 1 which forms part of a soleplate 6 of an iron.

Figure 4 shows a fourth example of an external wall 1 which forms part of a gas burner cap 7 and of a pan support 8 of a gas hob.

### LIST OF REFERENCE CHARACTERS/SIGNS

- 1: external wall
- 2: substrate
- 3: first layer
- 4: second layer
- 5.: control panel
- 6.: soleplate
- 7.: gas burner cap
- 8.: pan support
- 9.: housing
- 10.: home appliance
- d: total layer thickness
- d₁: first layer thickness
- d₂: second layer thickness

## Claims

1. An external wall (1), particularly for a housing, of a home appliance, comprising a substrate (2), a first layer (3) arranged on the substrate (2), and a second layer (4) arranged on the first layer (3), wherein the material of the substrate (2) comprises or is stainless steel, and wherein the material of the first layer (3) comprises or is titanium (Ti) and the material of the second layer (4) comprises or is titanium aluminum nitride (AlTiN); or wherein the material of the first layer (3) comprises or is chrome (Cr) and the material of the second layer (4) comprises or is diamond-like-carbon (DLC).

2. External wall according to claim 1, second alternative, **characterized in that** the material of the first layer (3) is chrome (Cr) or Cr-CrN-CrCN.

3. External wall (1), particularly for a housing, of a home appliance, comprising a substrate (2), a first layer (23) arranged on the substrate (2), and a second layer (4) arranged on the first layer (3), wherein the material of the substrate (2) comprises or is aluminum, wherein the material of the first layer comprises or is titanium (Ti) and the material of the second layer comprises or is titanium nitride (TiN); or wherein the material of the first layer comprises chrome (Cr) and the material of the second layer comprises chrome nitride (CrN);

4. External wall (1) according to any of the preceding claims, **characterized in that** a total layer thickness (d) of the first and second layer (3, 4) is between 1 µm and 5 µm.

5. External wall (1) according to any of the preceding claims, **characterized in that** the external wall (1) forms part of a control panel (5) for controlling at least one component of the home appliance.

6. External wall (1) according to any of the claims 1 to 4, **characterized in that** the external wall (1) forms part of a soleplate (6) of an iron.

7. External wall (1) according to any of the claims 1 to 4, **characterized in that** the external wall (1) forms part of a gas burner cap (7) and/or a pan support (8) of a gas hob.

8. Housing (9) for a home appliance, comprising at least one external wall (1) according to any of the preceding claims.

9. Home appliance (10), comprising a housing (9) according to claim 8 and/or comprising at least one external wall (1) according to any of claims 1 to 7.
